# EUROPÄISCHE PATENTSCHRIFT

(11) **EP 0 655 020 B1**
(45) Veröffentlichungstag und Bekanntmachung des Hinweises auf die Patenterteilung: **29.01.1997**
(21) Anmeldenummer: 94918723.1
(22) Anmeldetag: 16.06.1994
(51) Int. Cl.: B23K 1/005

(54) **VERFAHREN UND VORRICHTUNG ZUR HERSTELLUNG EINER KONTAKTMETALLISIERUNG**
PROCESS AND DEVICE FOR METALLIZING A CONTACT AREA
PROCEDE ET DISPOSITIF DE METALLISATION D'UNE ZONE DE CONTACT

(30) Priorität: 17.06.1993 DE 4320055
(43) Veröffentlichungstag der Anmeldung: 31.05.1995
(73) Patentinhaber: FRAUNHOFER-GESELLSCHAFT ZUR FÖRDERUNG DER ANGEWANDTEN FORSCHUNG E.V., 80636 München (DE)
(72) Erfinder: AZDASHT, Ghassem, D-14052 Berlin (DE)
(74) Vertreter: Böck, Bernhard, Dipl.-Ing.
(86) Internationale Anmeldenummer: DE9400678
(87) Internationale Veröffentlichungsnummer: WO9500279

(56) Entgegenhaltungen:
- EP-A- 0 423 433
- DE-A- 4 038 765
- FR-A- 2 605 176
- US-A- 3 304 403
- US-A- 4 899 924
- US-A- 4 906 812
- PATENT ABSTRACTS OF JAPAN vol. 17, no. 645 (M-1517) 30. November 1993 & JP,A,52 008 258 (NIPPON STEEL CORP) 20. August 1993

## Beschreibung

Die vorliegende Erfindung betrifft ein Verfahren bzw. eine Vorrichtung zur Herstellung einer Kontaktmetallisierung.

Im Stand der Technik sind verschiedene Verfahren zur Herstellung von Kontaktmetallisierungen bekannt, bei denen die Kontaktmetallisierung beispielsweise galvanisch, chemisch, durch Aufdampfen oder mittels Siebdruck auf eine Kontaktfläche aufgebracht wird. Diese bekannten Verfahren erweisen sich sowohl wegen der komplexen Durchführung als auch der zur Durchführung der Verfahren benötigten, aufwendigen Vorrichtungen als sehr kostenintensiv. Dies führt dazu, daß beispielsweise die Herstellungskosten für einen bondfähigen oder auch im Flipchip-Verfahren applizierbaren Chip im wesentlichen durch die Kosten für die Herstellung der sogenannten "Bumps" bestimmt sind. Besonders gravierend wirken sich die mit der Herstellung von Kontaktmetallisierungen verbundenen Kosten im Bereich der Muster- oder Kleinserienfertigung aus.

Die DE-A-40 38 765 offenbart ein Verfahren zur Herstellung einer Kontaktmetallisierung, bei dem zu einem Lotmaterial-Formkörper ausgebildetes Lotmaterial einem Substrat zugeführt und zur Verbindung mit der Kontaktfläche durch einen Laserstrahl mit Energie beaufschlagt wird.

Der vorliegenden Erfindung liegt die Aufgabe zugrunde, ein Verfahren bzw. eine Vorrichtung zu schaffen, das bzw. die eine kostengünstige Herstellung von Kontaktmetallisierungen selbst bei Muster- oder Kleinserienfertigung ermöglicht.

Diese Aufgabe wird durch ein Verfahren mit den Merkmalen des Anspruchs 1 gelöst.

Bei dem erfindungsgemäßen Verfahren wird zu einem Lotmaterial-Formkörper ausgebildetes Lotmaterial mit einer in einer Kapillare geführten, stempelartig wirkenden Energieübertragungseinrichtung gegen eine Kontaktfläche eines Substrats transportiert und zur Umformung und Verbindung mit der Kontaktfläche durch die Energieübertragungsvorrichtung mit Energie beaufschlagt.

Bei dem erfindungsgemäßen Verfahren wird die Energieübertragungseinrichtung einerseits für den Transport des Lotmaterial-Formkörpers zur Kontaktfläche verwendet; andererseits dient die Energieübertragungseinrichtung zur Übertragung der Schmelzenergie in den Formkörper, um die Umformung des Formkörpers bzw. die Lötverbindung des Formkörpers mit der Kontaktfläche zu ermöglichen.

Das erfindungsgemäße Verfahren ermöglicht durch eine geeignete Abstimmung zwischen dem Kapillarenquerschnitt und der Formkörpermasse die Ausbildung von in ihrer Größe und Form genau festgelegten Kontaktmetallisierungen, ohne daß die beispielsweise von den galvanischen Kontaktmetallisierungsverfahren her bekannten komplexen Masken oder Schablonen verwendet werden müssen. Darüber hinaus ist es erstmals möglich, beispielsweise als Lötkugeln ausgebildete Formkörper einzeln und in genau definierter Größe zu verarbeiten und nicht wie bisher üblich, eine Lötpaste zu verwenden, die eine Verteilung von in ihrem Durchmesser stark schwankenden Lötkugeln aufweist.

Als besonders vorteilhaft erweist es sich, wenn als Energieübertragungseinrichtung eine aus zumindest einer Lichtleitfaser bestehende Lichtleitfaseranordnung verwendet wird, die zu Übertragung von Laserenergie dient. Eine derartige Ausbildung der Energieübertragungseinrichtung schafft die Möglichkeit, die zur Umformung eines Formkörpers bzw. dessen Verbindung mit einer Kontaktfläche benötigte Energie genau dosiert einzubringen.

Bei einer Ausführungsform des erfindungsgemäßen Verfahrens wird der Lotmaterial-Formkörper einem Ausgaberaum am Ende der Kapillare zugeführt, derart, daß er vor Kontaktierung mit der Kontaktfläche zwischen einem Kontaktende der Energieübertragungseinrichtung und einer Ausgabeöffnung der Kapillare angeordnet ist. Diese Alternative bietet die Möglichkeit, vorgefertigte, in ihrer Form und Größe exakt definierte Formkörper zu verarbeiten.

Bei einer anderen Ausführungsform des Verfahrens wird das Lotmaterial in kontinuierlicher Form, etwa als Lotdraht, dem Ausgaberaum am Ende der Kapillare zugeführt, derart, daß ein Lotmaterialende in den zwischen einem Kontaktende der Energieübertragungseinrichtung und einer Ausgabeöffnung der Kapillare ausgebildeten Ausgaberaum hineinragt, so daß die Ausbildung des Formkörpers durch Energiebeaufschlagung des Lotmaterialendes im Wege einer Umschmelzung erfolgt, die im Ausgaberaum stattfindet.

Hierdurch entfällt die Notwendigkeit, die Formkörper bereits fertig ausgebildet zur Verfügung zu stellen; vielmehr ist es möglich, etwa einen Draht als Ausgangsmaterial für die Formköprper zu verwenden, so daß der Zwischenschritt der Herstellung von Formkörpern einer bestimmten Form vor Durchführung des Verfahrens zur Herstellung der Kontaktmetallisierung entfällt.

Die Abtrennung des bei der Ausbildung zunächst mit dem kontinuierlichen Lotmaterial zusammenhängenden Formkörpers kann ebenfalls durch Energiebeaufschlagung mittels der Energieübertragungseinrichtung erfolgen.

Zudem besteht aber auch die Möglichkeit, die Abtrennung des zunächst mit dem kontinuierlichen Lotmaterial zusammenhängend ausgebildeten Formkörpers mechanisch durchzuführen, indem der Formkörper durch das Kontaktende der Energieübertragungseinrichtung oder eine geeignete Abtrennvorrichtung vom kontinuierlichen Lotmaterial abgetrennt wird.

Als besonders vorteilhaft erweist es sich, wenn der Formkörper vor Applizierung auf der Kontaktfläche durch eine etwa als Vakuumeinrichtung ausgebildete Halteeinrichtung im Ausgaberaum gehalten wird. Dies ermöglicht eine exakte Positionierung der Ausgabeöffnung der Kapillare über der Kontaktfläche, ohne daß ein Kontakt zwischen der Ausgabeöffnung und der Kontaktfläche notwendig sein müßte, um den Formkörper verliersicher im Ausgaberaum zu halten.

Zur Lösung der vorgenannten Aufgabe weist die Vorrichtung zur Herstellung einer Kontaktmetallisierung die Merkmale des Anspruchs 8 auf.

Die erfindungsgemäße Vorrichtung ist mit einem Kapillarkörper zur Aufnahme und Führung einer stempelartig ausgebildeten, an eine Energiequelle anschließbaren Energieübertragungseinrichtung versehen, wobei der Kapillarkörper eine Zuführeinrichtung zur Zuführung von Lotmaterial aufweist, die in einen Ausgaberaum am Ende der Kapillare führt, der zwischen einem Kontaktende der Energieübertragungseinrichtung und einer Ausgabeöffnung der Kapillare ausgebildet ist.

Diese Vorrichtung ermöglicht eine Durchführung des vorstehenden Verfahrens, wobei die vorgenannten Vorteile erzielbar sind.

Wenn die Energieübertragungseinrichtung aus einer zumindest eine Lichtleitfaser aufweisenden Lichtleitfaseranordnung besteht, kann die zur Umformung des Formkörpers und zur Verbindung des Formkörpers mit der Kontaktfläche notwendige Energie besonders gut dosiert und in sehr konzentrierter Weise innerhalb kürzester Zeit in den Formkörper eingebracht werden.

Wenn der Ausgaberaum mit einer als Vakuumeinrichtung ausgebildeten Halteeinrichtung versehen ist, ist zum einen eine genaue Positionierung des etwa nach Art eines Bondkopfs ausgeführten Kapillarkörpers oberhalb der Kontaktfläche möglich, wobei der Formkörper durch die Vakuumeinrichtung verliersicher im Ausgaberaum gehalten wird. Zum anderen kann durch die Vakuumeinrichtung eine Unterstützung der Zuführung des Formkörpers aus der Zuführeinrichtung in den Ausgaberaum zur dortigen Positionierung für den nachfolgenden Umformungsvorgang erfolgen.

Als besonders vorteilhaft erweist es sich, wenn der Ausgaberaum des Kapillarkörpers zumindest teilweise als eine Formmatrize ausgebildet ist. Insbesondere, wenn die Formmatrize auswechselbar am Kapillarkörper angeordnet ist, kann eine einfache und schnelle Anpassung der Vorrichtung an wechselnde Anforderungen hinsichtlich der Form der Kontaktmetallisierungen erfolgen.

Nachfolgend werden das erfindungsgemäße Verfahren sowie die erfindungsgemäße Vorrichtung anhand beispielhafter Ausführungsformen unter Bezugnahme auf die beiliegenden Zeichnungen näher erläutert. Es zeigen:
**Fig. 1** eine Kontaktmetallisierungsvorrichtung in einer ersten Ausführungsform unmittelbar vor der Applikation einer Kontaktmetallisierung;
**Fig. 2** die in **Fig. 1** dargestellte Kontaktmetallisierungsvorrichtung bei der Applikation der Kontaktmetallisierung;
**Fig. 3** eine Ausführungsform einer Kontaktmetallisierung;
**Fig. 4** eine weitere Ausführungsform einer Kontaktmetallisierung;
**Fig. 5** eine weitere Ausführungsform einer Kontaktmetallisierungsvorrichtung unmittelbar vor der Applikation einer Kontaktmetallisierung;
**Fig. 6** die in **Fig. 5** dargestellte Kontaktmetallisierungsvorrichtung bei Applikation der Kontaktmetallisierung;
**Fig. 7** eine Lotdrahtvorschubeinrichtung;
**Fig. 8** die in **Fig. 5** dargestellte Kontaktmetallisierungsvorrichtung unter Verwendung von mit Solltrennstellen versehenem Lotdraht;
**Fig. 9** eine weitere Ausführungsform einer Kontaktmetallisierung.

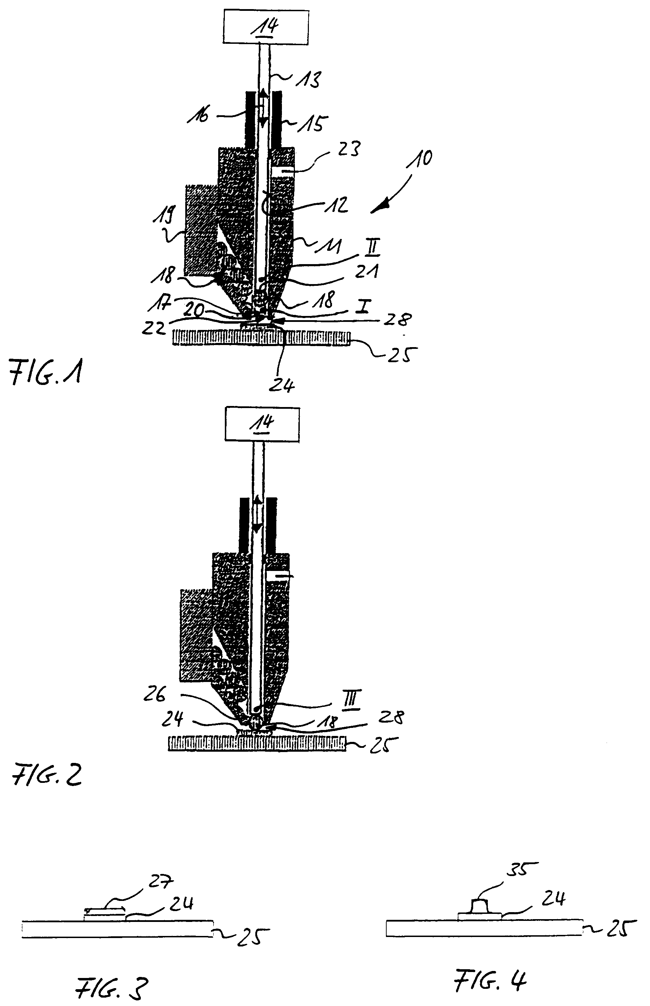

**Fig. 1** zeigt eine Kontaktmetallisierungsvorrichtung 10 mit einem Kapillarkörper 11, der eingeführt in eine Kapillare 12 eine Lichtleitfaser 13 aufweist, die an eine Laserquelle 14 angeschlossen ist. Die Lichtleitfaser 13 ist über eine am Kapillarkörper 11 angeordnete Vorschubeinrichtung 15 in Richtung des Doppelpfeils 16 hin- und herbewegbar.

Im Kapillarkörper 11 ist eine hier als Zuführungskanal 17 ausgebildete Zuführeinrichtung vorgesehen, die zur Zuführung einzelner Lotmaterial-Formkörper 18 aus einem Lotmaterialreservoir 19 in einen Ausgaberaum 20 dient, der am unteren Ende der Kapillare 12 ausgebildet ist.

Der Kapillarkörper 11 kann nach Art eines Bondkopfs mehrachsig bewegbar ausgebildet sein. Anstatt der hier beispielhaft als Lichtleitfaser 13 ausgebildeten Energieübertragungseinrichtung, die an eine Laserquelle 14 angeschlossen ist, ist es auch möglich, als Energieübertragungseinrichtung etwa eine Thermode zu verwenden, die mit elektrischer Energie versorgt wird.

In der in **Fig. 1** dargestellten Konfiguration befindet sich die Lichtleitfaser 13 in ihrer oberen Endstellung, so daß der Ausgaberaum 20 der Kapillare 12 an einem Ende durch ein Kontaktende 21 der Lichtleitfaser 13 und an seinem anderen Ende durch eine Ausgabeöffnung 22 der Kapillare 12 begrenzt wird.

In dem in **Fig. 1** dargestellten Ausführungsbeispiel der Kontaktmetallisierungsvorrichtung 10 befindet sich quer zur Kapillare 12 und mit dieser verbunden ein Ansaugkanal 23, der mit einer außerhalb des Kapillarkörpers 11 angeordneten, hier nicht näher dargestellten Vakuumeinrichtung verbunden ist. Der Ansaugkanal 23 befindet sich über der Kapillare 12 in Saugverbindung mit dem Ausgaberaum 20.

Die Kontaktmetallisierungsvorrichtung 10 dient zur Applikation einer Kontaktmetallisierung auf einer hier als Lötpad 24 ausgebildeten Kontaktfläche auf einem Substrat 25, das als Leiterplatte, Chip oder dergleichen ausgebildet sein kann.

Nachfolgend wird die Applikation einer Kontaktmetallisierung auf dem Lötpad 24 des Substrats 25 ausgehend von der in **Fig. 1** gestrichelt dargestellten Ausgangsstellung I der Lichtleitfaser 13 bzw. deren Kontaktendes 21 beschrieben. In der Ausgangsstellung I befindet sich das Kontaktende 21 bei dem hier dargestellten Ausführungsbeispiel im wesentlichen bündig zur Ausgabeöffnung 22, so daß in dem schräg nach oben ansteigend ausgebildeten Zuführungskanal 17 angeordnete Lotmaterial-Formkörper 18 durch die Lichtleitfaser 13 im Zuführungskanal 17 zurückgehalten werden. Bewegt sich nun das Kontaktende 21 der Lichtleitfaser 13 in die in **Fig. 1** mit durchgezogenem Linienverlauf dargestellten Ladestellung II, wird ein Formkörper 18 aus dem Zuführungskanal 17 unter Schwerkrafteinfluß in den Ausgaberaum 20 geladen. Dabei ist die in **Fig. 1** nicht näher dargestellte Vakuumeinrichtung aktiviert, so daß der im Ausgaberaum 20 befindliche Lotmaterial-Formkörper 18 mittels des über den Ansaugkanal 23 und die Kapillare 12 im Ausgaberaum 20 wirkenden Vakuums gegen das Kontaktende 21 der Lichtleitfaser 13 gesogen wird und daran positioniert anliegt.

Das im Ausgaberaum 20 wirkende Vakuum unterstützt somit einerseits die Überführung des Lotmaterial-Formkörpers 18 aus dem Zuführungskanal 17 in den Ausgaberaum 20 und hält andererseits den Lotmaterial-Formkörper 18 in definierter Anlage gegen das Kontaktende 21. Somit kann abweichend von der in **Fig. 1** gewählten Darstellung der Kapillarkörper 11 mit dem im Ausgaberaum 20 angeordneten Materialformkörper 18 auch beliebig weit entfernt vom Lötpad 24 angeordnet sein, ohne daß der Lotmaterial-Formkörper 18 aus dem Ausgaberaum 20 herausfallen kann.

Ausgehend von der in **Fig. 1** dargestellten Ladestellung II des Kontaktendes 21 der Lichtleitfaser 13 wird das Kontaktende 21 nun, wie in **Fig. 2** dargestellt, in Richtung auf den Lötpad 24 in eine Anschlagstellung III überführt, in der der Lotmaterial-Formkörper 18 auf dem Lötpad 24 aufliegt und über das Kontaktende 21 bei Bedarf Druck auf den Lotmaterial-Formkörper 18 ausgeübt werden kann. In der Anschlagstellung III erfolgt eine Aktivierung der Laserquelle 14, so daß eine Beaufschlagung des Lotmaterial-Formkörpers 18 mit Laserenergie durch die Lichtleitfaser 13 erfolgen kann. Durch die Beaufschlagung mit Laserenergie wird ein Erweichen des Lotmaterial-Formkörpers 18 bewirkt, so daß dieser zur Ausbildung einer Kontaktmetallisierung mit dem Lötpad 24 verbunden werden kann. Bei Bedarf kann das Umschmelzen durch entsprechende Betätigung der Vorschubeinrichtung 15 mit einer Druckbeaufschlagung überlagert werden.

**Fig. 3** zeigt beispielhaft das Aussehen einer Kontaktmetallisierung 27 , wenn bei Umformung des Lotmaterial-Formkörpers 18 ein in den **Fig. 1 und 2** dargestellter Spalt 28 erhalten bleibt. Bei Erzeugung der Kontaktmetallisierung 27 dringt der Lotmaterial-Formkörper 18 während der Umformung in den zwischen dem Lötpad 24 und der Ausgabeöffnung 22 ausgebildeten Spalt 28 ein, um etwa eine Kontaktmetallisierung auszubilden, die in ihrer Form und Größe im wesentlichen mit dem Lötpad 24 übereinstimmt.

Wenn im Bereich der Ausgabeöffnung 22 die Kapillare 12 als Formmatrize 26 ausgebildet ist, so kann durch die Umformung des Lötmaterial-Formkörpers 18 und dessen Verbindung mit dem Lötpad 24 die in **Fig. 4** dargestellte, in der Form durch die Formmatrize 26 vorgegebene Kontaktmetallisierung 35 ausgebildet werden. Hierbei ist abweichend von den Darstellungen in den **Fig. 1 und 2** die Ausgabeöffnung 22 im wesentlichen spaltfrei gegenüber dem Lötpad 24 positioniert.
Ausgehend von der vorhergehenden Beschreibung wird deutlich, daß durch eine entsprechende Gestaltung der Formmatrize 26 in Form und Größe beliebige Kontaktmetallisierungen erzeugt werden können.

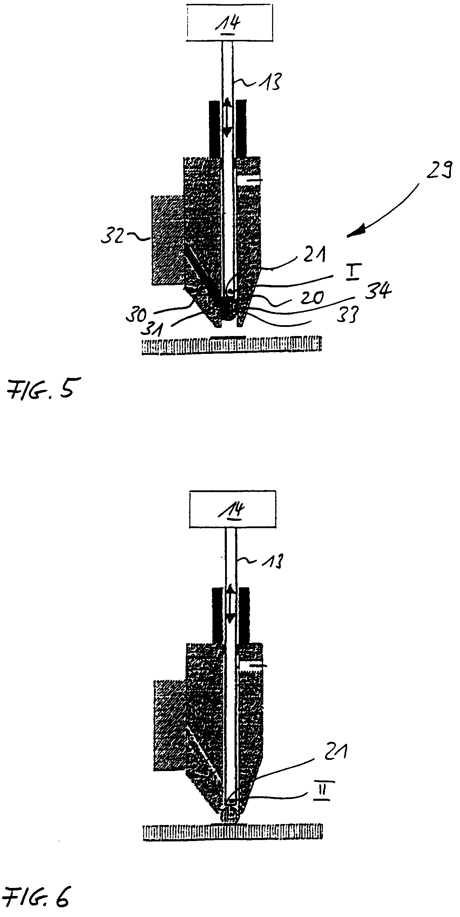

Die **Fig. 5** und **6** zeigen in einer weiteren Ausführungsform eine Kontaktmetallisierungsvorrichtung 29, bei der das Lotmaterial anstatt in Form von Lotmaterial-Formkörpern 18 in Form eines Lotdrahts 30 zugeführt wird. Hieraus ergeben sich einige Abweichungen der Kontaktmetallisierungsvorrichtung 29 gegenüber der Kontaktmetallisierungsvorrichtung 10, die im wesentlichen einen Zuführungskanal 31 und ein Lotmaterialreservoir 32 betreffen, wohingegen die übrigen Komponenten und Bauteile der Kontaktmetallisierungsvorrichtung 29, die dieselben Bezugszeichen wie die entsprechenden Bauteile und Komponenten der Kontaktmetallisierungsvorrichtung 10 aufweisen, identisch mit diesen ausgebildet sind.

Bei der Kontaktmetallisierungsvorrichtung 29 dient das Lotmaterialreservoir 32 zur Aufnahme einer nicht näher dargestellten Drahtspule, von der mittels einer ebenfalls nicht näher dargestellten Abwickeleinrichtung der Lotdraht 30 abgewickelt und durch den Zuführungskanal 31 in den Ausgaberaum 20 vorgeschoben wird.

Bei der in **Fig. 5** dargestellten Kontaktmetallisierungsvorrichtung 29 ist die Ausgangsstellung I durch die in **Fig. 5** dargestellte Konfiguration bestimmt, bei der sich das Kontaktende 21 der Lichtleitfaser 13 in seiner zurückgezogenen Stellung befindet und ein Lotdrahtende 33 unterhalb des Kontaktendes 21 in den Ausgaberaum 20 vorragt.

In dieser Stellung wird die Laserquelle 14 aktiviert, um über die Lichtleitfaser 13 das Lotdrahtende 33 mit Laserenergie zu beaufschlagen. Auf Grund der Erwärmung des Laserdrahtendes 33 und des damit verbundenen Anschmelzens bildet sich aus dem Lotdrahtende 33 ein Lotmaterial-Formkörper 34, der zusammenhängend mit dem Lotdraht 30 ausgebildet ist.

Nach Ausbildung des in **Fig. 5** dargestellten Lotmaterial-Formkörpers 34 kann die Laserquelle 14 abgeschaltet werden, so daß der Lotmaterial-Formkörper 34 bei Überführung des Kontaktendes 21 der Lichtleitfaser 13 in seine in **Fig. 6** dargestellte Anschlagstellung II durch das Kontaktende 21 mechanisch vom Lotdraht 30 abgeschert wird und sich ein neues Lotdrahtende 33 ausbildet, das für einen nachfolgenden Kontaktmetallisierungsvorgang zur Verfügung steht.

Der Lotmaterial-Formkörper 34 befindet sich nunmehr in Zwischenlage zwischen dem Lötpad 24 und dem Kontaktende 21 der Lichtleitfaser 13 in einer Stellung, die übereinstimmt mit der in **Fig. 2** dargestellten Stellung, so daß wie vorstehend beschrieben, die Umformung des Lotmaterial-Formkörpers 34 zur Verbindung mit dem Lötpad 24 und zur Ausbildung einer Kontaktmetallisierung erfolgen kann.

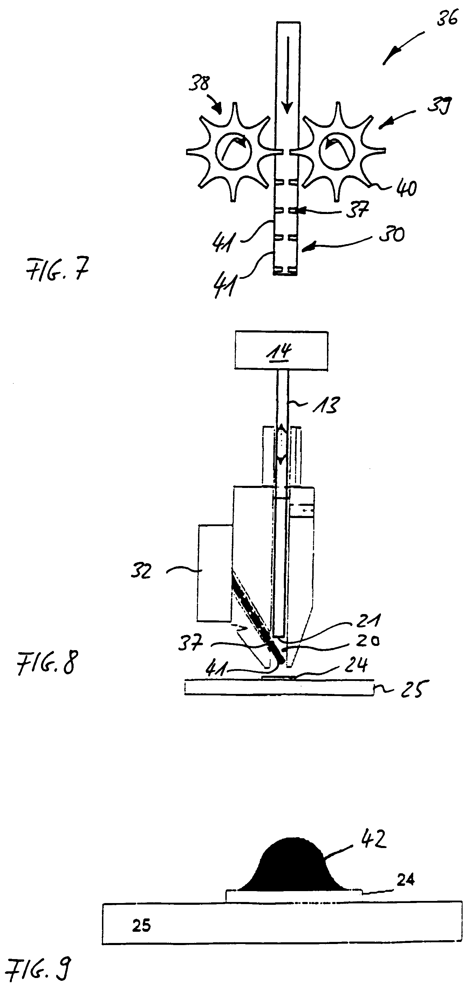

**Fig. 7** zeigt eine Prinzipdarstellung einer Lotdraht-Vorschubeinrichtung 36, die beispielsweise am Lotmaterialreservoir 32 (Fig. 8) angeordnet sein kann und sowohl zum Drahtvorschub im Zuführungskanal 31 als auch zur Ausbildung von im Durchmesser verringerten Solltrennstellen 37 dient. Hierzu weist die Vorschubeinrichtung zwei gegeneinander rotierende Zahnräder 38, 39 mit Zähnen 40 auf, von denen zumindest eines angetrieben wird. Dabei prägen sich die Zähne 40 in den Lotdraht 30 ein, und es werden über die Solltrennstellen 37 miteinander verbundene Lotdraht-Formkörper 41 ausgebildet.

**Fig. 8** zeigt einen mit Solltrennstellen 37 versehenen Lotdraht 30, dessen in Vorschubrichtung vorderstes Lotdraht-Formstück 41 in den Ausgaberaum 20 eingeführt ist. Aus der Darstellung wird deutlich, daß ein Abtrennen des Lotdraht-Formstücks 41 durch das Kontaktende 21 der Lichtleitfaser 13 oder eine andere geeignete Abtrenneinrichtung auf Grund der im Querschnitt stark geschwächten Solltrennstelle 37 erheblich vereinfacht wird; insbesondere dann, wenn gleichzeitig mit dem Abtrennvorgang eine Energiebeaufschlagung der Solltrennstelle 37 mit Laserenergie erfolgt. Nach dem Abtrennen fällt das Formstück 41 auf den Lötpad 24 oder wird mit dem Kontaktende 21 der Lichtleitfaser 13 dorthin bewegt, mit Laserenergie beaufschlagt und in eine Kontaktmetallisierung 42 (**Fig. 9**) umgeschmolzen.

Sämtliche der vorstehend beispielhaft geschilderten Verfahrensvarianten und die dabei verwendeten Vorrichtungvarianten weisen den Vorteil auf, daß auf der Oberfläche eines beliebig ausgebildeten Substrats etwa wie in **Fig. 9** dargestellte, hügelartig ausgebildete Kontaktmetallisierungen in beliebiger Flächenverteilung (ball-gate-array) appliziert werden können.

## Patentansprüche

1. Verfahren zur Herstellung einer Kontaktmetallisierung (27) bei dem zu einem Lotmaterial-Formkörper (18, 34, 41) ausgebildetes Lotmaterial mittels einer in einer Kapillare (12) geführten, stempelartig wirkenden Energieübertragungseinrichtung (13) gegen eine Kontaktfläche (24) eines Substrats (25) transportiert und zur Umformung und Verbindung mit der Kontaktfläche (24) durch die Energieübertragungseinrichtung (13) mit Energie beaufschlagt wird.

2. Verfahren nach Anspruch 1,
**dadurch gekennzeichnet, daß**
als Energieübertragungseinrichtung eine aus zumindest einer Lichtleitfaser (13) bestehende Lichtleitfaseranordnung verwendet wird, die zur Übertragung von Laserenergie dient.

3. Verfahren nach Anspruch 1 oder 2,
**dadurch gekennzeichnet, daß**
der Lotmaterial-Formkörper (18) einem Ausgaberaum (20) am Ende der Kapillare (12) zugeführt wird, derart, daß der Lotmaterial-Formkörper (18) vor Kontaktierung mit der Kontaktfläche (24) zwischen einem Kontaktende (21) der Energieübertragungseinrichtung (13) und einer Ausgabeöffnung (22) der Kapillare (12) angeordnet ist.

4. Verfahren nach Anspruch 1 oder 2,
**dadurch gekennzeichnet, daß**
das Lotmaterial in kontinuierlicher Form, vorzugsweise als Lotdraht (30), einem Ausgaberaum (20) am Ende der Kapillare (12) zugeführt wird, derart, daß ein Lotmaterialende (33) in den zwischen einem Kontaktende (21) der Energieübertragungseinrichtung (13) und einer Ausgabeöffnung (22) der Kapillare (12) ausgebildeten Ausgaberaum (20) hineinragt und die Ausbildung eines Lotmaterial-Formkörpers (34) durch Energiebeaufschlagung mittels der Energieübertragungseinrichtung (13) über einen Umschmelzvorgang erfolgt.

5. Verfahren nach Anspruch 4,
**dadurch gekennzeichnet, daß**
durch die Energiebeaufschlagung mittels der Energieübertragungseinrichtung (13) eine Abtrennung des Lotmaterial-Formkörpers (34) vom kontinuierlichen Lotmaterial (30) erfolgt.

6. Verfahren nach Anspruch 4,
**dadurch gekennzeichnet, daß**
der Lotmaterial-Formkörper (34) nach Energiebeaufschlagung des Lotmaterialendes (33) zusammenhängend mit dem kontinuierlichen Lotmaterial (30) ausgebildet ist und anschließend durch das Kontaktende (21) der Energieübertragungseinrichtung (13) vom Lotmaterial abgetrennt wird.

7. Verfahren nach einem oder mehreren der vorangehenden Ansprüche,
**dadurch gekennzeichnet, daß**
der Lotmaterial-Formkörper (18, 34) vor Applizierung auf der Kontaktfläche (24) durch eine vorzugsweise als Vakuumeinrichtung ausgebildete Halteeinrichtung im Ausgaberaum (20) gehalten wird.

8. Vorrichtung zur Durchführung des Verfahrens nach einem oder mehreren der Ansprüche 1 bis 7, mit einem Kapillarkörper (11) zur Aufnahme und Führung einer stempelartig ausgebildeten, an eine Energiequelle anschließbaren Energieübertragungseinrichtung (13), wobei der Kapillarkörper (11) mit einer Zuführeinrichtung (17, 31) für Lotmaterial versehen ist, die in einen Ausgaberaum (20) am Ende der Kapillare (12) führt, der zwischen einem Kontaktende (21) der Energieübertragungseinrichtung (13) und einer Ausgabeöffnung (22) der Kapillare (12) ausgebildet ist.

9. Vorrichtung nach Anspruch 8,
**dadurch gekennzeichnet, daß**
die Energieübertragungseinrichtung aus einer zumindest eine Lichtleitfaser (13) aufweisenden Lichtleitfaseranordnung besteht.

10. Vorrichtung nach Anspruch 8 oder 9,
**dadurch gekennzeichnet, daß**
der Ausgaberaum (20) mit einer als Vakuumeinrichtung ausgebildeten Halteeinrichtung versehen ist.

11. Vorrichtung nach einem oder mehreren der vorangehenden Ansprüche,
**dadurch gekennzeichnet, daß**
der Ausgaberaum (20) zumindest teilweise als Formmatrize (26) ausgebildet ist.

## Claims

1. Method of metallising a contact area (27) in which solder material formed into a solder material moulded body (18, 34, 41) by means of an energy transmission device (13) guided in a capillary (12) and acting as a punch is transported against a contact face (24) of a substrate (25) and is acted on with power by the power transmission device (13) for shaping and connection to the contact face (24).

2. Method according to claim 1, characterised in that as an energy transmission device a fibreoptic device consisting of at least one optical fibre (13) is used, which serves to transmit laser energy.

3. Method according to claim 1 or 2, characterised in that the solder material moulded body (18) is supplied to an output chamber at the end of the capillary (12), in such a manner that the solder material moulded body (18) is disposed before contacting with the contact face (24) between a contact end (21) of the energy transmission device (13) and an output aperture (22) of the capillary (12).

4. Method according to claim 1 or 2, characterised in that the solder material is supplied in continuous form, preferably as a solder wire (30), to an output chamber (20) at the end of the capillary (12) in such a manner that a solder material end (33) projects into the output chamber (20) formed between a contact end (21) of the energy transmission device (13) and an output aperture (22) of the capillary (12) and the formation of a solder material moulded body (34) takes place by the application of energy by means of the energy transmission device (13) via a recasting process.

5. Method according to claim 4, characterised in that, by the energy application by means of the energy transmission device (13), separation of the solder material moulded body (34) from the continuous solder material (30) is effected.

6. Method according to claim 4, characterised in that the solder material moulded body (34), after the application of energy to the solder material end (33), is formed connected to the continuous solder material (30) and is then separated from the solder material by the contact end (21) of the energy transmission device (13).

7. Method according to one or more of the preceding claims, characterised in that the solder material moulded body (18, 34) is held in the output chamber (20) by a holding device preferably in the form of a vacuum device before application to the contact face (24).

8. Apparatus for carrying out the method according to one or more of claims 1 to 7, having a capillary body (11) for receiving and guiding a punch-like energy transmission device (13) attachable to an energy source, wherein the capillary body (11) is provided with a supply device (17, 31) for solder material, which leads into an output chamber (20) at the end of the capillary (12), which is formed between a contact end (21) of the energy transmission device (13) and an output aperture (22) of the capillary (12).

9. Apparatus according to claim 8, characterised in that the energy transmission device consists of a fibreoptic device having at least one optical fibre (13).

10. Apparatus according to claim 8 or 9, characterised in that the output chamber (20) is provided with a holding device formed as a vacuum device.

11. Apparatus according to one or more of the preceding claims, characterised in that the output chamber (20) is formed at least partly as a bottom die (26).

## Revendications

1. Procédé de réalisation d'une zone métallisée de contact (27), selon lequel une matière de soudage, se présentant sous forme d'un corps de forme en matière de soudage (18, 34, 41), est transportée, de façon à venir en appui sur une surface de contact (24) d'un substrat (25), au moyen d'un dispositif de transmission d'énergie (13) guidé dans un tube capillaire (12) et agissant à la façon d'un poinçon et reçoit un apport d'énergie au moyen du dispositif de transmission d'énergie (13) en vue de sa mise en forme et de sa liaison avec la surface de contact (24).

2. Procédé selon la revendication 1, caractérisé en ce que, comme dispositif de transmission d'énergie, on utilise un agencement à fibre optique qui est constitué d'au moins une fibre optique (13) et qui sert à la transmission d'une énergie laser.

3. Procédé selon la revendication 1 ou 2, caractérisé en ce que le corps de forme en matière de soudage (18) est amené à une chambre de sortie (20) située à l'extrémité du tube capillaire (12), d'une façon telle que le corps de forme en matière de soudage (18) soit disposé, avant la mise en contact avec la surface de contact (24), entre une extrémité de contact (21) du dispositif de transmission d'énergie (13) et un orifice de sortie (22) du tube capillaire (12).

4. Procédé selon la revendication 1 ou 2, caractérisé en ce que la matière de soudage est amenée, sous une forme continue, de préférence sous forme d'un fil de soudage (30), à une chambre de sortie (20) située à l'extrémité du tube capillaire (12), d'une façon telle qu'une extrémité de matière de soudage (33) fasse saillie dans la chambre de sortie (20) formée entre une extrémité de contact (21) du dispositif de transmission d'énergie (13) et un orifice de sortie (22) du tube capillaire (12) et que la formation d'un corps de forme en matière de soudage (34) s'effectue au moyen d'une opération de fusion par apport d'énergie à l'aide du dispositif de transmission d'énergie (13).

5. Procédé selon la revendication 4, caractérisé en ce que l'apport d'énergie au moyen du dispositif de transmission d'énergie (13) permet qu'une séparation du corps de forme en matière de soudage (34) vis-à-vis de la matière de soudage continue (30) se produise.

6. Procédé selon la revendication 4, caractérisé en ce qu'après l'apport d'énergie à l'extrémité de matière de soudage (33), le corps de forme en matière de soudage (34) est formé en étant attaché à la matière de soudage continue (30) et est ensuite séparé de la matière de soudage par l'extrémité de contact (21) du dispositif de transmission d'énergie (13).

7. Procédé selon une ou plusieurs des revendications dépendantes, caractérisé en ce qu'avant l'application sur la surface de contact (24), le corps de forme en matière de soudage (18, 34) est maintenu dans la chambre de sortie (20) au moyen d'un dispositif de maintien se présentant de préférence sous forme d'un dispositif de vide.

8. Dispositif de mise en oeuvre du procédé suivant une ou plusieurs des revendications 1 à 7, comprenant un corps a tube capillaire (11) servant à recevoir et guider un dispositif de transmission d'énergie (13) réalisé en forme de poinçon et agencé de façon à pouvoir être raccordé à une source d'énergie, le corps à tube capillaire (11) étant pourvu d'un dispositif (17, 31) d'amenée d'une matière de soudage qui débouche dans une chambre de sortie (20) située à l'extrémité du tube capillaire (12) et formée entre une extrémité de contact (21) du dispositif de transmission d'énergie (13) et un orifice de sortie (22) du tube capillaire (12).

9. Dispositif selon la revendication 8, caractérisé en ce que le dispositif de transmission d'énergie est constitué d'un agencement à fibre optique comportant au moins une fibre optique (13).

10. Dispositif selon la revendication 8 ou 9, caractérisé en ce que la chambre de sortie (20) est pourvue d'un dispositif de maintien se présentant sous forme d'un dispositif de vide.

11. Dispositif selon une ou plusieurs des revendications précédentes, caractérisé en ce que la chambre de sortie (20) est réalisée au moins partiellement sous forme d'une matrice de formage (26).
